# EUROPEAN PATENT SPECIFICATION

(11) **EP 0 674 387 B1**
(45) Date of publication and mention of the grant of the patent: **31.05.2000**
(21) Application number: 95301842.1
(22) Date of filing: 20.03.1995
(51) Int. Cl.: H03J 7/02

(54) **Automatic frequency control method and apparatus therefor**
System und Verfahren zur automatischen Frequenzregelung
Appareil et méthode de contrôle automatique de fréquence

(30) Priority: 25.03.1994 KR 9406091
(43) Date of publication of application: 27.09.1995
(73) Proprietor: Samsung Electronics Co., Ltd., Suwon-city, Kyungki-do 441-370 (KR)
(72) Inventor: Choi, Yang-Seok, Iungrang-gu Seoul (KR)
(74) Representative: Neill, Alastair William

(56) References cited:
- EP-A- 0 413 153
- EP-A- 0 526 836
- IEEE TRANSACTIONS ON COMMUNICATIONS, vol. com-32, no. 8, August 1984 pages 935-947, FRANCIS D. NATALI: 'AFC Tracking Algorithms'

## Description

### Background of the Invention

The present invention relates to an automatic frequency control (AFC) method and apparatus therefor, and more particularly, though not exclusively, to an automatic frequency control method and apparatus therefor which are used for detecting a synchronous signal from a signal which is M-ary phase-shift keying modulated and transmitted.

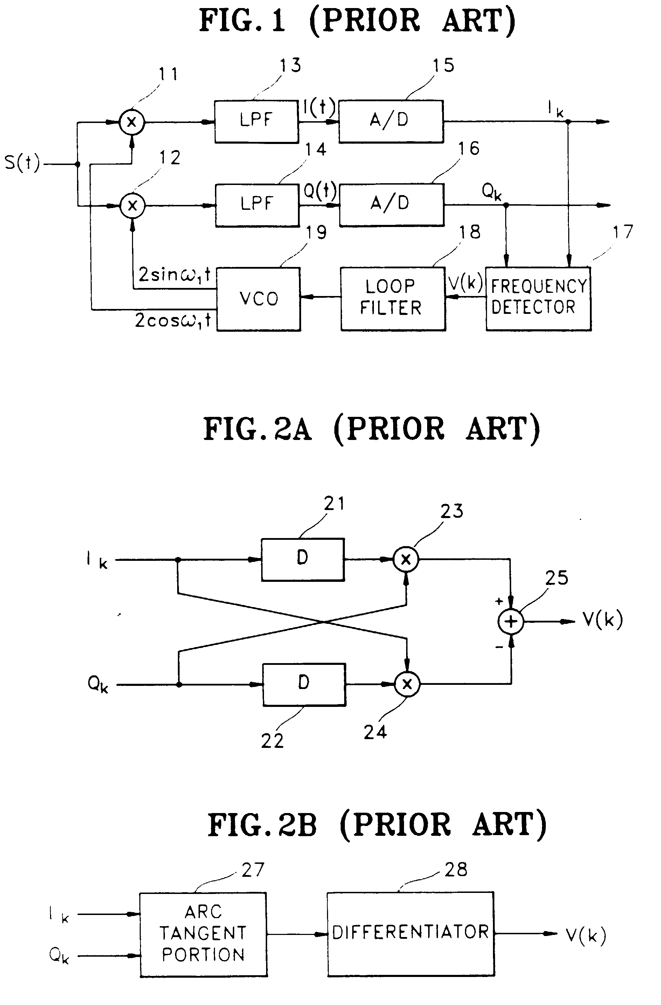

Digital transmission technology is widely used since it guarantees high quality transmission and improves frequency efficiency. With this technology, a receiver of a synchronous detecting method performs a signal demodulation process after detecting the synchronous signal from the signal which is transmitted after being modulated. In order to detect a synchronous signal from the received signal, the oscillation frequency of the local carrier wave in the receiver has to match the frequency of the modulated carrier wave and no phase error should be present. As a result, if this is achieved the original signal can be perfectly detected. To achieve this, a local carrier wave is synchronized with the carrier of the modulated signal. The conventional technology for detecting the synchronous signal from the received signal will be described, referring to Figures. 1, 2A and 2B.

Figure 1 is a block diagram showing an automatic frequency control apparatus for conventional quadrature phase-shift keying (QPSK) demodulation.

In Figure 1, the received signal S(t) is input to multipliers 11 and 12. Multipliers 11 and 12 multiply the received signals by first and second local carrier waves which are output from voltage-controlled oscillator (VCO) 19 and have a phase difference of 90°. Here, the first and second local carrier waves can be represented as 2*cos*ω₁t and 2*sin*ω₁t, respectively.

The output signals of multipliers 11 and 12 are low-pass-filtered by low-pass filters (LPF) 13 and 14, respectively, to become baseband signals. When Gaussian noise is not included in the received signal, the received signal S(t) can be expressed as A*cos*[ω₀t+φ(t)]. Low-pass filter 13 outputs an I-channel (in-phase) signal I(t) expressed as A*cos*[Δωt+φ(t)], and low-pass filter 14 outputs a Q-channel (quadrature) signal Q(t) expressed as A*sin*[Δωt+φ(t)]. Here, Δω=ω₁-ω₀.

The output signals of low-pass filters 13 and 14 are digitized in analog-to-digital (A/D) converters 15 and 16, respectively, and are output as demodulated signals. At the same time, the digitized signals (Iₖ and Qₖ) are input to a frequency detector 17.

The signals output from A/D converters 15 and 16 each have a phase φ(t) varied for every symbol period T_{b}. For example, in quadrature phase-shift keying, phase φ(t) is 45°, 135°, -45° or -135° and is varied according to the bit stream information of a transmission side and symbol period T_{b}.

A frequency detector 17 receives the two channel signals Iₖ and Qₖ, to generate frequency offset information V(t). The frequency offset is generated since the actual oscillation frequency (local carrier wave) of a receiver and the frequency of the received carrier wave do not coincide.

Frequency offset information V(k) is input to VCO 19 through a loop filter 18. VCO 19 generates the first and second local carrier waves according to the input frequency offset information. The first and second local carrier waves have the same frequency and a phase difference of 90°, for generating the I- and Q-channel signals.

The technology for detecting the above-described frequency offset information is discussed in "AFC Tracking Algorithms," *IEEE Transactions on Communications,* Vol. COM-32, No. 8, pp.935-947.

Figure 2A shows a frequency detector using the cross product disclosed in the above reference.

The I-channel signal Iₖ, which is sampled and digitized, is applied to a delay circuit (D) 21 and a multiplier 24, and the Q-channel signal Qₖ, which is also sampled and digitized, is applied to a delay circuit 22 and a multiplier 23. Multiplier 23 multiplies the delayed I-channel signal by the input Q-channel signal, and multiplier 24 multiplies the delayed Q-channel signal by the input I-channel signal.

A subtractor 25 subtracts the output signal of multiplier 24 from the output signal of multiplier 23 and generates frequency offset information V(k) which is determined according to a sampling period Tₛ and symbol period T_{b}.

That is, when sampling period Tₛ is the same as symbol period T_{b}, i.e., Tₛ=T_{b}, subtractor 25 generates frequency offset information V(k) in accordance with the following.${\text{I}}_{\text{k}} \text{= A} \text{cos} {\text{(ΔωkT}}_{\text{s}} {\text{+ φ}}_{\text{k}} \text{)}$${\text{I}}_{\text{k-1}} \text{= A} \text{cos} {\text{[Δω(k-1)T}}_{\text{s}} {\text{+ φ}}_{\text{k-1}} \text{]}$${\text{Q}}_{\text{k}} \text{= A} \text{sin} {\text{(ΔωkT}}_{\text{s}} {\text{+ φ}}_{\text{k}} \text{)}$${\text{Q}}_{\text{k-1}} \text{= A} \text{sin} {\text{[Δω(k-1)T}}_{\text{s}} {\text{+ φ}}_{\text{k-1}} \text{]}$${\text{Q}}_{\text{k}} {\text{I}}_{\text{k} \text{-1}} \text{=} \frac{{\text{A}}^{\text{2}}}{\text{2}} {\text{sin(ΔωT}}_{\text{s}} {\text{+ φ}}_{\text{k}} {\text{- φ}}_{\text{k} \text{-1}} \text{) +} \frac{{\text{A}}^{\text{2}}}{\text{2}} \text{sin[Δω(2} \text{k} \text{- 1)} {\text{T}}_{\text{s}} {\text{+ φ}}_{\text{k}} {\text{+ φ}}_{\text{k} \text{-1}} \text{]}$${\text{I}}_{\text{k}} {\text{Q}}_{\text{k} \text{-1}} \text{=} \frac{{\text{- A}}^{\text{2}}}{\text{2}} {\text{sin(ΔωT}}_{\text{s}} {\text{+ φ}}_{\text{k}} {\text{- φ}}_{\text{k} \text{-1}} \text{) +} \frac{{\text{A}}^{\text{2}}}{\text{2}} \text{sin[Δω(2} \text{k} {\text{- 1)T}}_{\text{s}} {\text{+ φ}}_{\text{k}} {\text{+ φ}}_{\text{k} \text{-1}} \text{]}$${\text{∴ V(k) = Q}}_{\text{k}} {\text{I}}_{\text{k-1}} {\text{- I}}_{\text{k}} {\text{Q}}_{\text{k-1}} {\text{= A}}^{\text{2}} \text{sin} {\text{(ΔωT}}_{\text{s}} {\text{+ θ}}_{\text{k}} \text{)}$ Here, it is assumed that Δω=ω₁-ω₀, φ(t)=φₖ, kTₛ≤t<(k+1)Tₛ and θₖ=φₖ-φₖ₋₁.

On the other hand, when Tₛ<T_{b} (over-sampling: T_{b}=nTₛ, where n>1), frequency offset information V(k) generated from subtractor 25 is expressed as the following formula (20).

Here, when k is not equal to nl, then${\text{I}}_{\text{k}} \text{= A} \text{cos} {\text{(ΔωkT}}_{\text{s}} {\text{+ φ}}_{\text{l}} \text{)}$${\text{I}}_{\text{k-1}} \text{= A} \text{cos} {\text{[Δω(k-1)T}}_{\text{s}} {\text{+ φ}}_{\text{l}} \text{]}$${\text{Q}}_{\text{k}} \text{= A} \text{sin} {\text{(ΔωkT}}_{\text{s}} {\text{+ φ}}_{\text{l}} \text{)}$${\text{Q}}_{\text{k-1}} \text{= A} \text{sin} {\text{[Δω(k-1)T}}_{\text{s}} {\text{+ φ}}_{\text{l}} \text{]}$${\text{Q I}}_{\text{k}} {\text{}}_{\text{-1}} \text{=} \frac{{\text{A}}^{\text{2}}}{\text{2}} {\text{sin(ΔωT}}_{\text{s}} \text{) +} \frac{{\text{A}}^{\text{2}}}{\text{2}} \text{sin[Δω (2} \text{k} {\text{- 1)T}}_{\text{s}} {\text{+ 2φ}}_{\text{ℓ}} \text{]}$${\text{I}}_{\text{k}} {\text{Q}}_{\text{k}} {\text{}}_{\text{-1}} \text{=} \frac{{\text{- A}}^{\text{2}}}{\text{2}} {\text{sin(ΔωT}}_{\text{s}} \text{) +} \frac{{\text{A}}^{\text{2}}}{\text{2}} \text{sin[Δω(2} \text{k} {\text{- 1)T + 2φ}}_{\text{ℓ}} \text{]}$${\text{∴ V(k) = Q}}_{\text{k}} {\text{I}}_{\text{k-1}} {\text{- I}}_{\text{k}} {\text{Q}}_{\text{k-1}} {\text{= A}}^{\text{2}} \text{sin} {\text{(ΔωT}}_{\text{s}} \text{)}$ and when k is equal to nl, then${\text{I}}_{\text{k}} \text{= A} \text{cos} {\text{(ΔωkT}}_{\text{s}} {\text{+ φ}}_{\text{l}} \text{)}$${\text{I}}_{\text{k-1}} \text{= A} \text{cos} {\text{[Δω(k-1)T}}_{\text{s}} {\text{+ φ}}_{\text{l-1}} \text{]}$${\text{Q}}_{\text{k}} \text{= A} \text{sin} {\text{(ΔωkT}}_{\text{s}} {\text{+ φ}}_{\text{l}} \text{)}$${\text{Q}}_{\text{k-1}} \text{= A} \text{sin} {\text{[Δω(k-1)T}}_{\text{s}} {\text{+ φ}}_{\text{l-1}} \text{]}$${\text{Q}}_{\text{k}} {\text{I}}_{\text{k}} {\text{}}_{\text{-1}} \text{=} \frac{{\text{A}}^{\text{2}}}{\text{2}} {\text{sin(ΔωT}}_{\text{s}} {\text{+ φ}}_{\text{ℓ}} {\text{- φ}}_{\text{ℓ-1}} \text{) +} \frac{{\text{A}}^{\text{2}}}{\text{2}} \text{sin[Δω(2} \text{k} {\text{- 1)T}}_{\text{s}} {\text{+ φ}}_{\text{ℓ}} {\text{+ φ}}_{\text{ℓ-1}} \text{]}$${\text{I}}_{\text{k}} {\text{Q}}_{\text{k}} {\text{}}_{\text{-1}} \text{=} \frac{{\text{- A}}^{\text{2}}}{\text{2}} {\text{sin(ΔωT}}_{\text{s}} {\text{+ φ}}_{\text{ℓ}} {\text{- φ}}_{\text{ℓ-1}} \text{) +} \frac{{\text{A}}^{\text{2}}}{\text{2}} \text{sin[Δω(2} \text{k} {\text{- 1)T}}_{\text{s}} {\text{+ φ}}_{\text{ℓ}} {\text{+ φ}}_{\text{ℓ-1}} \text{]}$${\text{∴ V(k) = Q}}_{\text{k}} {\text{I}}_{\text{k-1}} {\text{- I}}_{\text{k}} {\text{Q}}_{\text{k-1}} {\text{= A}}^{\text{2}} \text{sin} {\text{(ΔωT}}_{\text{s}} {\text{+φ}}_{\text{ℓ}} \text{)}$ Therefore,$\text{V} \text{(} \text{k} \text{) =} {\text{A}}^{\text{2}} {\text{sin(ΔωT}}_{\text{s}} \text{) for k ≠} \text{n} \text{ℓ} \text{V} \text{(} \text{k} \text{) =} {\text{A}}^{\text{2}} {\text{sin(ΔωT}}_{\text{s}} {\text{+ φ}}_{\text{ℓ}} \text{) for k ≠} \text{n} \text{ℓ}$ wherein l=k/n and l is an integer not over [x]=x.

Figure 2B shows a frequency detector using an arc tangent operation. An arc tangent portion 27 receives the signals (Qₖ and Iₖ) of two channels and performs the arc tangent operation by taking the Q-channel signal Qₖ as a numerator and the I-channel signal Ik as a denominator. The output signal of arc tangent portion 27 is input to a differentiator 28 which generates frequency offset information V(k) expressed by formulas 21 and 22.

First, from formulas 1 and 3, F(k) is defined as follows when Tₛ=T_{b}:${\text{F(k) = tan}}^{\text{-1}} {\text{(Q}}_{\text{k}} {\text{/I}}_{\text{k}} \text{)} {\text{= ΔωkT}}_{\text{s}} {\text{+ φ}}_{\text{k}} \text{∴ V(k) = F(k)-F(k-1)} {\text{= Δω(k-k+1)T}}_{\text{s}} {\text{+ (φ}}_{\text{k}} {\text{-φ}}_{\text{k-1}} \text{)} {\text{= ΔωT}}_{\text{s}} {\text{+ θ}}_{\text{k}}$

In the case of over-sampling and k≠nl, from formulas 8 and 10, we get${\text{F(k) = tan}}^{\text{-1}} {\text{(Q}}_{\text{k}} {\text{/I}}_{\text{k}} \text{)} {\text{= ΔωkT}}_{\text{s}} {\text{+ φ}}_{\text{l}}$ and from formulas 9 and 11, we get${\text{F(k-1) = tan}}^{\text{-1}} {\text{(Q}}_{\text{k-1}} {\text{/I}}_{\text{k-1}} \text{)} {\text{= Δω(k-1)T}}_{\text{s}} {\text{+ φ}}_{\text{l}}$$\text{∴ V(k) = F(k)-F(k-1)} {\text{= ΔωT}}_{\text{s}}$

On the other hand, in over-sampling where k=nl, from formulas 14 and 16, we get${\text{F(k) = tan}}^{\text{-1}} {\text{(Q}}_{\text{k}} {\text{/I}}_{\text{k}} \text{)} {\text{= ΔωkT}}_{\text{s}} {\text{+ φ}}_{\text{l}}$ and from formulas 15 and 17, we get${\text{F(k-1) = tan}}^{\text{-1}} {\text{(Q}}_{\text{k-1}} {\text{/I}}_{\text{k-1}} \text{)} {\text{= Δω(k-1)T}}_{\text{s}} {\text{+ φ}}_{\text{l-1}}$$\text{∴ V(k) = F(k) - F(k-1)} {\text{= ΔωT}}_{\text{s}} {\text{+ φ}}_{\text{l}} {\text{- φ}}_{\text{l-1}} {\text{= ΔωT}}_{\text{s}} {\text{+ θ}}_{\text{l}}$ Therefore,$\text{V} \text{(} \text{k} {\text{) = ΔωT}}_{\text{s}} \text{for k≠} \text{n} \text{ℓ} \text{V} \text{(} \text{k} {\text{) = ΔωT}}_{\text{s}} {\text{+ φ}}_{\text{ℓ}} \text{for k≠} \text{n} \text{ℓ}$ wherein l=k/n and l is an integer not over [x]=x.

The above formula 21 represents the output signal of differentiator 28 in the case where Tₛ is equal to T_{b}, and formula 22 represents the output signal of differentiator 28 in the case of over-sampling, that is, Tₛ<T_{b} and T_{b}=nTₛ. Terms θₖ and θₗ, whose values are varied according to the transmitted information, are excluded from the formula, in order to detect the exact frequency. Here, θₖ and θₗ represent the difference between the phase information transmitted from the current symbol period and the phase information transmitted from immediately preceding symbol period, that is, the phase difference between symbols during transmission. Hereinafter, θₖ is referred to as transmission phase information.

A QPSK demodulator having a phase difference detector for performing an arc tangent operation as above and performing an AFC function is disclosed in European Patent Application No. 0 526 836 A2.

However, as shown in formulas 7 and 21, transmission phase information θₖ is included in the formula in the case where the sampling frequency is equal to the symbol rate. Thus, it is impossible to detect the exact frequency directly proportional to frequency offset Δω. Also, in the case of over-sampling, as shown in formulas 20 and 22, it is impossible to detect the exact frequency, since transmission phase information θₗ remains in a sample which undergoes symbol transition.

Although the performance of frequency detection can be improved according to the degree of over-sampling, the cost of hardware for over-sampling is increased for symbol rates above 20MHz, such as in the case of a direct broadcasting satellite. This problem can also be generated in a differentiator AFC circuit or a discrete Fourier transform AFC circuit.

EP-A-413 153 discloses a device for an angular modulated signal is quadrature demoldulated into first and second signal vectors by a local carrier signal having a frequency signal difference from a received carrier signal which is angular modulated by a modulating signal comprising symbols representative of binary one and zero at a symbol interval. In the modulating signal, a particular symbol sequence comprises the symbols in a predetermined manner and results in the first signal vector. A data symbol sequence comprises the symbols to represent data and results in the second signal vector. The first signal vector has inphase and quadrature phase amplitudes which are converted to phase values substantially at the symbol interval. An individual error is provided by comparing a phase variation between two phase values with a reference variation determined by the predetermined manner. Such individual errors are averaged into a phase error which is used in correcting the second signal vector. It is possible to compute the phase error by calculating the phase variation using a reference variation determined by the predetermined manner and the received carrier signal.

### Summary of the Invention

It is an aim of embodiments of the present invention to provide an automatic frequency control method for automatically controlling frequency by obtaining a reference phase which is the closest to the phase of a transmitted signal using the quantization characteristic of the phase during transmission and the phase difference between the currently sampled signal and the immediately preceding sampled signal, after sampling the signal transmitted according to a phase-shift keying method, and detecting a frequency offset.

It is another aim of embodiments of the present invention to provide an automatic frequency control apparatus suitable for performing the above method.

According to the present invention there is provided an automatic frequency control method in which a MPSK-modulated signal is received, a frequency offset signal is generated using the phase information of the modulated signal, and the local oscillation frequency of a receiver is controlled on the basis of the frequency offset signal, comprises the steps of: sampling the received signal at a predetermined sampling frequency; generating a phase detection signal having the phase difference information between the currently sampled signal and the immediately preceding sampled signal; determining a reference phase which is the closest to the phase difference information of the phase detection signal among the reference phase values of the M-ary phase-shift keying of the modulated signal, as transmission phase information of the received signal; and generating a frequency offset signal corresponding to the phase difference between the phase difference information and the determined transmission phase information.

Suitably, said phase detection signal generating step comprises a normalization step where a first phase detection signal Uₖ is generated according to${\text{U}}_{\text{k}} \text{=} \frac{{\text{R}}_{\text{k}} {\text{R}}_{\text{k}}^{\text{*}} {\text{}}_{\text{-1}}}{\left|{\text{R}}_{\text{k}}\right| \text{x} \left|{\text{R}}_{\text{k} \text{-1}}\right|} \text{=} \text{e} {\text{}}^{\text{j} {\text{(θ}}_{\text{k}} \text{+ΔωT)}} \text{≡} {\text{C}}_{\text{k}} \text{+} {\text{jS}}_{\text{k}}$ by using a currently sampled signal Rₖ and an immediately preceding sampled signal Rₖ₋₁ where θ_{*k*} represents the difference between phase information transmitted from the current symbol period and the phase information transmitted from the immediately preceding symbol period, and ΔωT is a frequency offset signal.

Suitably, said phase detection signal generating step comprises a complex conjugation operation step where a second phase detection signal U'ₖ is generated according to${\text{U'}}_{\text{k}} {\text{= R}}_{\text{k}} {\text{R*}}_{\text{k-1}}$ by using a currently sampled signal Rₖ and an immediately preceding sampled signal Rₖ₋₁.

Suitably, said frequency offset signal generating step comprises a first frequency offset signal generation step where a first frequency offset signal *sin*(ΔωT) is generated according to$\text{sin} {\text{(ΔωT) = Im[U}}_{\text{k}} {\text{e}}^{\text{-jψi}} \text{]}$ using said reference phase ψᵢ and said phase detection signal Uₖ.

Suitably, said frequency offset signal generating step further comprises a second frequency offset signal generation step where a second frequency offset signal ΔωT is generated using the phase of said first frequency offset signal *sin*(ΔωT).

Suitably, in said transmission phase information determination step, when said phase difference information ∠Uₖ of phase detection signal Uₖ includes a second frequency offset signal ΔωT between -π/M and π/M determined according to the number M of the reference phase of the M-ary phase-shift keying, and when said phase difference information ∠Uₖ, second frequency offset signal ΔωT and transmission phase information θₖ satisfy ΔωT = ∠Uₖ - θₖ, a reference phase ψᵢ is determined as the reference phase which is the closest to said phase difference information.

According to another aspect of the present invention there is provided an automatic frequency control apparatus in which a MPSK-modulated signal is received, a frequency offset signal is generated using the phase information of the modulated signal, and the local oscillation frequency of a receiver is controlled on the basis of the frequency offset signal, comprises: sampling means for sampling the received signal at a predetermined sampling frequency and outputting the sampled signal; phase difference detection means for receiving the currently sampled signal from the sampling means and for generating a phase detection signal having phase difference information between the currently sampled signal and the immediately preceding sampled signal stored therein; and means for receiving the phase detection signal to determine a reference phase which is the closest to the phase difference information of the phase detection signal among the reference phase values of the M-ary phase-shift keying of the modulated signal, as transmission phase information of the received signal, and for generating a frequency offset signal determined according to the phase difference between the phase difference information and the transmission phase information.

Suitably, said phase difference detection means (32) comprises normalization means for receiving the currently sampled signal (Rₖ) and the immediately preceding sampled signal (Rₖ₋₁) and generating said phase detection signal (Uₖ) .

Suitably, said phase difference detection means comprises a complex conjugation operator for receiving the currently sampled signal (Rₖ) and the immediately preceding sampled signal (Rₖ₋₁) and generating said phase detection signal (Uₖ).

Suitably, said frequency offset signal generation means comprises:
determination means for storing a plurality of critical values determined by said reference phase values, receiving said phase detection signal and outputting the reference phase value determined by said phase difference information of said phase detection signal and said plurality of critical values; and
first frequency offset signal generator for receiving said transmission phase information and said phase detection signal and generating first frequency offset signal which is an imaginary number component generated through the complex conjugation operation between the received transmission phase information and phase detection signal.

Suitably, said first frequency offset generator receives said reference phase signal e^{-jψi} and said phase detection signal from said determination means and generates a first frequency offset signal *sin*(ΔωT) determined according to$\text{sin} {\text{(ΔωT) = Im[U}}_{\text{k}} {\text{e}}^{\text{-jψi}} \text{]} {\text{= S}}_{\text{k}} \text{cos} {\text{ψ}}_{\text{i}} {\text{- C}}_{\text{k}} \text{sin} {\text{ψ}}_{\text{i}} \text{.}$

Suitably, said automatic frequency control apparatus further comprises a second frequency offset signal generator for receiving said first frequency offset signal *sin*(ΔωT) and generating a second frequency offset signal ΔωT through an arc sine operation.

Suitably, in said determination means, when said phase difference information ∠Uₖ of said phase detection signal includes a second frequency offset signal ΔωT between -π/M and π/M determined according to the number M of reference phase of phase-shift keying, and when said phase difference information ∠Uₖ, second frequency offset signal ΔωT and transmission phase information θₖ satisfy ΔωT = ∠Uₖ - θₖ, a reference phase ψᵢ is determined as the reference phase which is the closest to said phase difference information.

Suitably, said sampling means samples said received signal at the sampling frequency equal to the symbol rate.

Suitably, said frequency offset signal generator comprises:
a first sign generator for receiving the QPSK-modulated phase detection signal and generating a first sign signal which is the value of a sign function with respect to the difference obtained by subtracting a second component signal constituting said phase detection signal from first component signal constituting said phase detection signal;
a second sign generator for generating a second sign signal which is the value of a sign function with respect to the sum of said first and second component signals;
a subtractor for subtracting said second sign signal from said first sign signal;
a first adder for summing said first and second sign signals;
a third sign generator for outputting a third sign signal which is the sign function value of the signal output from said subtractor;
a fourth sign generator for outputting a fourth sign signal which is the sign function value of the signal output from said adder;
a first multiplier for multiplying said first component signal by the output signal of said third sign generator;
a second multiplier for multiplying said second component signal by the output signal of said fourth sign generator; and
a second adder for summing the output signals of said first and second multipliers and generating said first frequency offset signal.

Suitably, said frequency offset signal generator comprises:
a control signal generator for receiving the QPSK-modulated phase detection signal and generating a selection control signal determined according to a first sign function value with respect to the difference obtained by subtracting the second component signal constituting said phase detection signal from the first component signal constituting said phase detection signal and a second sign function value with respect to the sum of said first and second component signals, said control signal generator generating said selection control signal so that the first component signal is selected as said first frequency offset signal if the first and second sign function values are greater than zero, the inverted signal of the first component signal is selected as said first frequency offset signal if the first sign function value is less than zero and the second sign function value is greater than zero, the inverted signal of the second component signal is selected as said first frequency offset signal if the first and second sign function values are less than zero, and the second component signal is selected as said first frequency offset signal if the first sign function value is greater than zero and the second sign function value is less than zero;
a first signal inverter for inverting and outputting said first component signal;
a second signal inverter for inverting and outputting said second component signal; and
selection means comprising four signal inputs connected for receiving said first and second component signals and the output signals of said first and second signal inverters, for selecting one of said four input signals according to said selection control signal and outputting said selected signal as said first frequency offset signal.

Suitably, said automatic frequency control apparatus further comprises a second frequency offset signal generator for receiving said first frequency offset signal and generating a second frequency offset signal through an arc sign operation.

Suitably, said first component signal is a real number component of said phase detection signal and said second component signal is an imaginary number component of said phase detection signal.

Suitably, said sampling means samples said received signal at the sampling frequency equal to the symbol rate.

### Brief Description of the Drawings

The above advantages of the present invention will become more apparent by describing in detail preferred embodiments thereof, by way of example only, with reference to the attached drawings in which:
Figure 1 is a block diagram showing an automatic frequency control apparatus for conventional QPSK demodulation;
Figures 2A and 2B are block diagrams of a conventional frequency detector;
Figure 3 is a diagram showing the relation between transmission phase information and a reference phase signal according to the present invention;
Figure 4 is a block diagram showing a frequency detector according to a preferred embodiment of the present invention;
Figure 5 is a discriminator curve showing the frequency offset;
Figures 6A and 6B are diagrams for illustrating how the transmission phase information is determined by the real and imaginary number components of the phase detection signal in the case of QPSK;
Figure 7 is a block diagram showing the frequency detector according to another preferred embodiment of the present invention in the case of QPSK; and
Figure 8 is a block diagram showing the frequency detector according to still another preferred embodiment of the present invention in the case of QPSK.

### Detailed Description of Preferred Embodiments

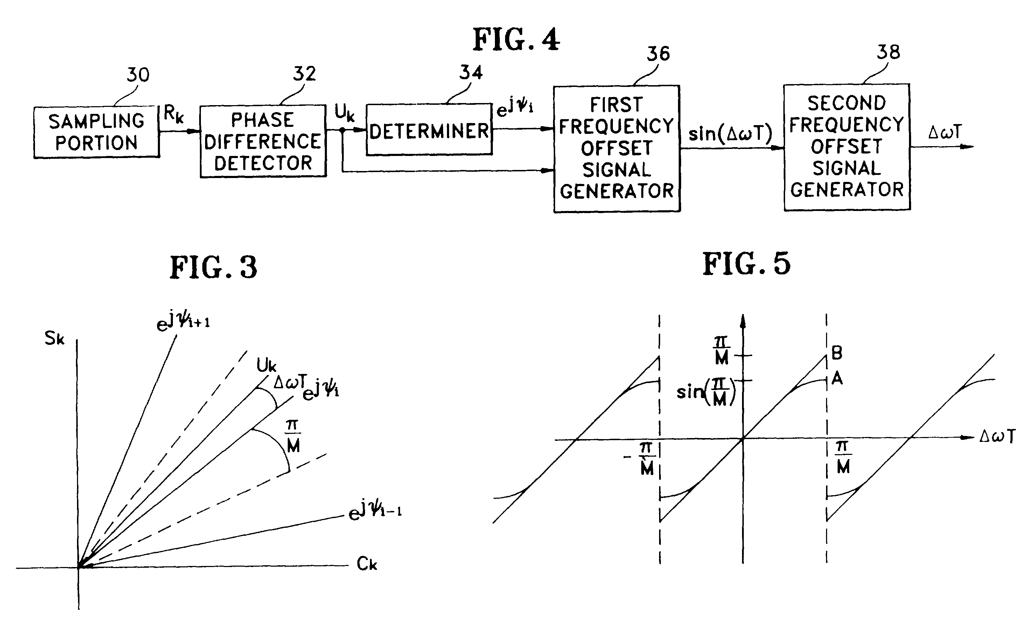

First, referring to Figure 3, an automatic frequency control method will be described below.

To sum up the automatic frequency control method according to the present invention, the transmitted signal is sampled at a symbol rate. If the sampling period is equal to the symbol period, the exact frequency is detected by eliminating the θk term through the assumption of the transmission phase information. That is, transmission phase information θₖ is assumed by determining a reference phase ψᵢ among a plurality of reference phases for transmitting information of the M-ary phase-shift keying as a reference phase. Here, the signal modulation using phase-shift keying varies transmission phase information θk, in order to transmit information. Therefore, according to the present invention, the frequency offset is detected so as to exactly perform the automatic frequency control by subtracting the assumed transmission phase information (reference phase) from the phase difference information between the currently sampled signal and the immediately preceding sampled signal.

The automatic frequency control method will be described in detail below.

If a signal modulated by M-ary phase-shift keying is transmitted, the receiver demodulates the received signal and the automatic frequency control apparatus samples the input signal.

The size rₖ' of a sampled signal Rₖ is varied by noise. Since the sampled signal includes a frequency offset signal ΔωT, the sampled signal Rₖ can be expressed as the following formula 23.${\text{R}}_{\text{k}} {\text{= I}}_{\text{k}} \text{+} {\text{jQ}}_{\text{k}} \text{=} {\text{r}}^{\text{'}} {\text{}}_{\text{k}} \text{e} {\text{}}^{\text{j} {\text{(φ}}_{\text{k}} {\text{+ΔωT}}_{\text{k}} \text{)}}$ where T=Tₛ=T_{b}.

As shown in the following formula 24, if normalization is performed using the currently sampled signal Rₖ and the immediately preceding sampled signal Rₖ₋₁, the obtained signal has the phase difference information contained therein. Thus, the signal is called a phase detection signal Uₖ which is obtained by compensating the magnitude of the signal distorted by noise.${\text{U}}_{\text{k}} \text{≡} \frac{{\text{R}}_{\text{k}} {\text{R}}_{\text{k}}^{\text{*}} {\text{}}_{\text{-1}}}{\left|{\text{R}}_{\text{k}}\right| \text{x} \left|{\text{R}}_{\text{k} \text{-1}}\right|} \text{=} \frac{\text{r} {\text{'}}_{\text{k}} \text{e} {\text{}}^{\text{j} {\text{(φ}}_{\text{k}} {\text{+ΔωT}}_{\text{k}} \text{)}} \text{r} {\text{'}}_{\text{k}} {\text{}}_{\text{-1}} \text{e} {\text{}}^{\text{-} \text{j} {\text{[φ}}_{\text{(} \text{k} \text{-1)}} {\text{+ΔωT}}_{\text{(} \text{k} \text{-1)}} \text{]}}}{\text{r} {\text{'}}_{\text{k}} \text{r} {\text{'}}_{\text{k}} {\text{}}_{\text{-1}}} \text{=} \text{e} {\text{}}^{\text{j} {\text{[φ}}_{\text{k}} {\text{-φ}}_{\text{(} \text{k} \text{-1)}} \text{+ΔωT]}} \text{=} \text{e} {\text{}}^{\text{j} {\text{(θ}}_{\text{k}} \text{+ΔωT)}} \text{≡} {\text{C}}_{\text{k}} \text{+} {\text{jS}}_{\text{k}}$

As shown in formula 24, phase difference signal ∠U of phase detection signal Uₖ always satisfies the following formulas 25 and 26.${\text{∠U}}_{\text{k}} {\text{= θ}}_{\text{k}} \text{+ ΔωT}$${\text{ΔωT = ∠U}}_{\text{k}} {\text{- θ}}_{\text{k}}$

Sampled signal Rₖ is the received signal, and phase detection signal Uₖ can be calculated by the above formula 24. Therefore, if transmission phase information θₖ, which is varied according to the transmitted information, is known, frequency offset signal ΔωT can be calculated exactly.

However, transmission phase information θₖ is varied by transmission information and can itself be used as transmission information in the case of differential encoding. Thus, if the frequency control apparatus does not operate smoothly, the receiver cannot exactly determine the transmission phase information. To solve the problem, the frequency offset can be detected by transmitting the reference phase information in a constant symbol interval. However, this method is inefficient in terms of signal transmission.

Therefore, according to the present invention, the following method is suggested.

Transmission phase information θₖ which is not a continuous value, is quantized by the reference phase of M-ary phase-shift keying, and is transmitted. During the transmission, transmission phase information θₖ is quantized to have reference phase values as shown in formula 27 below.${\text{φ}}_{\text{k}} {\text{∈{ψ}}_{\text{i}} {\text{|ψ}}_{\text{i}} \text{= 0,±} \frac{\text{2}}{\text{M}} \text{π,±} \frac{\text{4}}{\text{M}} \text{π,±} \frac{\text{6}}{\text{M}} \text{π,...,±} \frac{\text{M} \text{- 2}}{\text{M}} \text{π,π}}$

Therefore, the phase difference between the symbols can be detected from the sampled signal and the reference phase signal which is the closest to each of the above transmission phase information values can be detected even when a frequency offset exists.

Figure 3 schematically shows the relation between the transmission phase information and the reference phase signal according to the present invention. In the case where the range for selecting the reference phase signal which is the closest to transmission phase information θₖ is determined according to the following formula 28, it is determined that reference phase signal e^{jψi} and transmission phase information θk within the range have the same information.$\text{-π/M < ΔωT < π/M}$

Therefore, the automatic frequency control apparatus according to the present invention determines reference phase signal (e^{jψi} of Figure 3) which is located between the boundary lines (dotted lines) of Figure 3 including the detected phase detection signal Uₖ, as transmission phase information θₖ.

A parameter M of the above formula 28 has the same value as the number of reference phase signal e^{jψi} for phase-shift keying. If reference phase signal e^{jψi} regarded as transmission phase information θₖ is determined, frequency offset signal ΔωT having the relation shown in the above formula 25 or 26 is calculated by the following formula 30 or 31.

Frequency offset signal ΔωT is obtained using formula 29 for obtaining complex numbers A and B and the angle of two complex numbers. 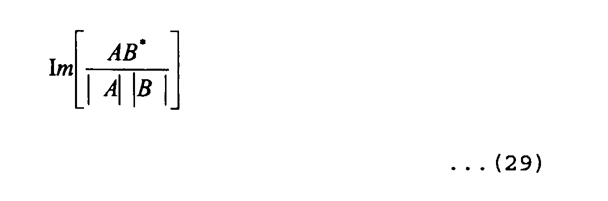 $\text{sin} {\text{(ΔωT) = Im[U}}_{\text{k}} {\text{e}}^{\text{-jψi}} \text{]} {\text{= Im[(C}}_{\text{k}} {\text{+jS}}_{\text{k}} {\text{)e}}^{\text{-jψi}} \text{]} {\text{= Im[(C}}_{\text{k}} {\text{+jS}}_{\text{k}} \text{) × (} \text{cos} {\text{ψ}}_{\text{i}} \text{-} \text{sin} {\text{ψ}}_{\text{i}} \text{)]} {\text{= S}}_{\text{k}} \text{cos} {\text{ψ}}_{\text{i}} {\text{- C}}_{\text{k}} \text{sin} {\text{ψ}}_{\text{i}} \text{_ ΔωT}$$\text{ΔωT =} {\text{sin}}^{\text{-1}} {\text{(S}}_{\text{k}} \text{cos} {\text{ψ}}_{\text{i}} {\text{-C}}_{\text{k}} \text{sin} {\text{ψ}}_{\text{i}} \text{)}$

By the above formula 30, the frequency offset signal can be more simply detected compared with the case of using formula 31. The apparatus realized using the above formula 23 can detect the frequency offset signal having a negligible error.

Next, the apparatus adopting the automatic frequency control method according to the present invention will be described in detail, referring to Figures 4-6.

Figure 4 is a block diagram showing a frequency detector according to a preferred embodiment of the present invention. The automatic frequency control apparatus shown in Figure 4 comprises a sampling portion 30, a phase difference detector 32, a determiner 34, a first frequency offset signal generator 36, and a second frequency offset signal generator 38. Here, phase difference detector 32 may comprise normalization means employing the above formula 24 or, in cases where a large amount of calculation is needed, a complex conjugation operator employing the formula${\text{U}}_{\text{k}} {\text{' = R}}_{\text{k}} {\text{R*}}_{\text{k-1}} \text{.}$

Now, the operation of the apparatus shown in Figure 4 will be described.

Sampling portion 30 samples and outputs the signal which is received and demodulated. According to the present invention, a sampling frequency fₛ of the signal is set as the same as symbol rate T_{b} so as to provide for less-expensive hardware.

When sampled signal Rₖ is input, phase difference detector 32 generates phase detection signal Uₖ or U'ₖ using the currently sampled signal Rₖ and the immediately preceding sampled signal Rₖ₋₁ being stored therein. Normalization means or complex conjugation operator selected by an external control signal (not shown) generates the phase detection signal at phase difference detector 32. The phase detection signal generated from phase difference detector 32 is applied to determiner 34 and first frequency offset signal generator 36. Since the same operation is performed in response to two phase detection signals Uₖ and U'ₖ, hereinafter, signal processing in response to only phase detection signal Uₖ will be described.

Determiner 34 determines transmission phase information θk using the critical values stored therein. That is, the reference phase which is the closest to phase difference information ∠Uₖ included in phase detection signal Uₖ, among the reference phase values which the received signal may have, is determined as transmission phase information θₖ of the modulated signal. Thus, determiner 34 outputs reference phase signal e^{jψi} having the transmission phase information. First frequency offset signal generator 36 receives phase detection signal Uₖ and reference phase signal e^{jψi} and generates first frequency offset signal *sin*(ΔωT).

First frequency offset signal generator 36 is realized by the above formula (30) and generates the imaginary number component of the complex value obtained by complex-conjugation-operating the input reference phase signal e^{jψi} and phase detection signal Uₖ. When the actual circuit is realized, first frequency offset signal generator 36 is operated according to the expression Sₖ*cos*ψᵢ-Cₖ*sin*ψᵢ by receiving real and imaginary number components Cₖ and Sₖ of phase detection signal Uₖ and reference phase information ψᵢ of determiner 34.

First frequency offset signal sin(ΔωT) output from first frequency offset generator 36 is applied to second frequency offset generator 38. Second frequency offset generator 38 outputs the arc sine value of the input first frequency offset signal *sin*(ΔωT). That is, a second frequency offset signal ΔωT is generated. All outputs of first and second frequency offset signal generators 36 and 38 can be used for generating a local oscillation signal by using frequency offset information.

Figure 5 graphically shows frequency offset information generated by the frequency offset signal generators. The characteristic curve of Figure 5 is obtained by a discriminator under the condition where |ΔωT| is less than π/M, |Δf| is less than fₛ/2M, and fₛ is equal to 1/T_{b}.

Curves A and B of Figure 5, obtained by the discriminator, are formed by first frequency offset signal generator 36 and second frequency offset signal generator 38, respectively. First frequency offset signal generator 36 generates non-linear discriminator curve A near boundary π/M. If non-linear discriminator curve A is a flat, increasing function, it is unnecessary to be linear such as curve B. Thus, the output signal of first frequency offset signal generator 36 can be used as frequency offset information in the actual apparatus.

Here, if second frequency offset signal generator 38 is used, the frequency offset information can be detected with great accuracy. However, there is a problem of an increase in the calculation amount.

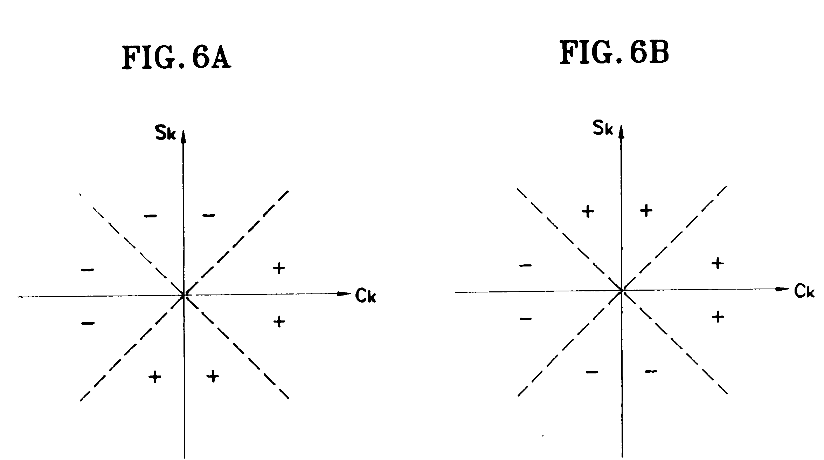

Figures 6-8 show the case where the automatic frequency control method of the present invention is applied to QPSK modulation. In QPSK modulation, the value of parameter M is four and reference phases ψ₀, ψ₁, ψ₂ and ψ₃ are 0, π/2, π and -π/2, respectively, according to formula (27).

The sum or difference between the real and imaginary number components Cₖ and Sₖ of phase detection signal Uₖ has the relation shown in Figures 6A and 6B. Figure 6A represents *sgn*(Cₖ-Sₖ) and Figure 6B represents *sgn*(Cₖ+Sₖ). The sum or difference between the real and imaginary number components Cₖ and Sₖ is determined as one of the regions divided by the coordinate axis and dotted diagonal lines, according to the sign function.

The sign function is defined as follows.$\text{sgn} \text{(x) = 1 for x>0}$$\text{sgn} \text{(x) = 0 for x=0}$$\text{sgn} \text{(x) = -1 for x<0}$

Reference phase information ψᵢ simultaneously corresponding to the regions determined in Figures 6A and 6B is transmission phase information θₖ. These relations are summarized as follows:
(a) if Cₖ-Sₖ>0 and Cₖ+Sₖ>0, then ψᵢ=0;
(b) if Cₖ-Sₖ<0 and Cₖ+Sₖ>0, then ψᵢ=π/2;
(c) if Cₖ-Sₖ<0 and Cₖ+Sₖ<0, then ψᵢ=π; and
(d) if Cₖ-Sₖ>0 and Cₖ+Sₖ<0 then, ψᵢ=-π/2.

Frequency offset signal ΔωT is determined by the reference phase determined by the above relations and formula (30). That is,
if ψᵢ is equal to zero, *sin*(ΔωT) is equal to Sₖ;
if ψᵢ is equal to *π*/2, *sin*(ΔωT) is equal to -Cₖ;
if ψᵢ is equal to π, *sin*(ΔωT) is equal to -Sₖ; and
if ψᵢ is equal to -π/2, *sin*(ΔωT) is equal to Cₖ.

Summarizing the above, the following formula (32) is formed.$\text{sin(ΔωT) =} {{\text{C}}^{̇}}_{\text{k}} \text{sgn[sgn(} {\text{C}}_{\text{k}} \text{-} {\text{S}}_{\text{k}} \text{)sgn(} {\text{C}}_{\text{k}} \text{+} {\text{S}}_{\text{k}} \text{)] +} {{\text{S}}^{̇}}_{\text{k}} \text{sgn[sgn(} {\text{C}}_{\text{k}} \text{-} {\text{S}}_{\text{k}} \text{)]}$

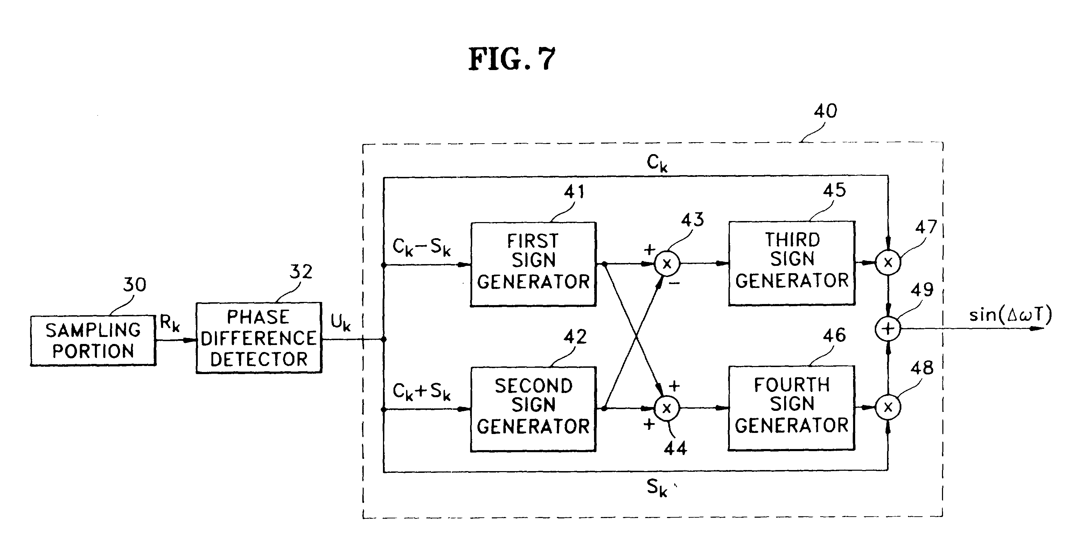

Figure 7 is a block diagram showing the frequency detector according to another preferred embodiment of the present invention. The apparatus of Figure 7 comprises a sampling portion 30, a phase difference detector 32, and a frequency offset signal generator 40 employing formula (32) regarding the QPSK method.

Frequency offset signal generator 40 comprises sign generators 41, 42, 45 and 46, a subtractor 43, adders 44 and 49, and multipliers 47 and 48. These constituent components are connected according to the above formula (32). In Figure 7, second frequency offset signal generator 38 (Figure 4) may be additionally connected to the output of frequency offset signal generator 40.

The operation of the apparatus shown in Figure 7 will now be described. Sampling portion 30 outputs signal Rₖ sampled at the sampling frequency which is the same as the symbol rate. Phase difference detector 32 performs the same operation as that of the block illustrated in Figure 4.

Phase detection signal Uₖ output from phase difference detector 32 is applied to first and second sign generators 41 and 42. Also, real number component signal Cₖ is applied to first multiplier 47 and imaginary number component signal Sₖ is applied to second multiplier 48. First sign generator 41 outputs the value of the sign function with respect to the difference (Cₖ-Sₖ) between the real and imaginary number components of phase detection signal Uₖ as the first sign signal. Second sign generator 42 outputs the value of the sign function with respect to the sum (Cₖ+Sₖ) of the real and imaginary number components of phase detection signal Uₖ as the second sign signal.

Subtractor 43 to which the first and second sign signals are applied subtracts the second sign signal from the first sign signal and outputs the result. First adder 44 receives the first and second sign signals, adds them together and outputs the result. Third sign generator 45 outputs the result value of the sign function with respect to the output of subtractor 43 as the third sign signal. Fourth sign generator 46 outputs the result value of the sign function with respect to the output of adder 44 as the fourth sign signal.

First multiplier 47 multiplies the third sign signal by real number component signal Cₖ and outputs the result. Second multiplier 48 multiplies the fourth sign signal by imaginary component signal Sₖ and outputs the result. Second adder 49 receives the outputs of multipliers 47 and 48 and generates first frequency offset signal *sin*(ΔωT).

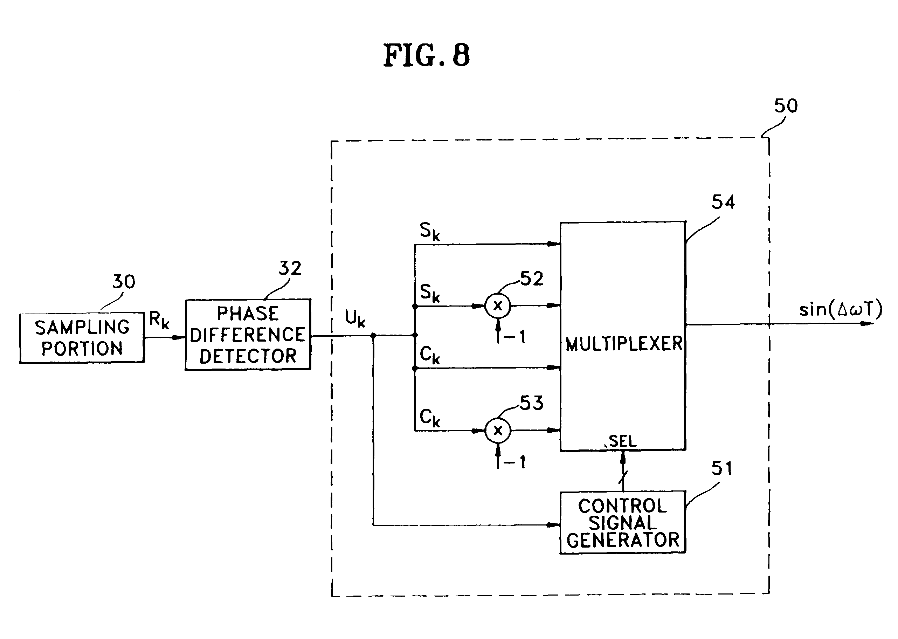

Figure 8 is a block diagram showing the frequency detector according to still another preferred embodiment of the present invention. The apparatus of Figure 8 comprises a sampling portion 30, a phase difference detector 32, and a frequency offset signal generator 50 employing formula (32) regarding the QPSK method.

In frequency offset signal generator 50, a control signal generator 51 receives phase detection signal Uₖ, signal inverters 52 and 53 invert the signal component Cₖ or Sₖ output from phase difference detector 32 and outputs the inverted signals, and multiplexer 54 selects the signals input according to the selection control signal (SEL) generated by control signal generator 51 and outputs the result as first frequency offset signal *sin*(ΔωT). In Figure 8, second frequency offset signal generator 38 (Figure 4) may be additionally connected to the output of frequency offset signal generator 50.

The operation of the apparatus shown in Figure 8 will be described. When sampling portion 30 outputs signal Rₖ sampled at the sampling frequency which is the same as the symbol rate, phase difference detector 32 performs the same operation as that of the block illustrated in Figure 4.

Real number component signal Cₖ of phase detection signal Uₖ is inverted by first signal inverter 52 and imaginary number component signal Sₖ is inverted by second signal inverter 53.

Control signal generator 51 is constructed for generating the selection control signal (SEL) according to the above formula (32). That is, the selection control signal is the sign signal of two bits representing the logical product of *sgn*(Cₖ-Sₖ) and *sgn*(Cₖ+Sₖ).

Multiplexer 54 selects one signal among four signals Sₖ, -Sₖ, Cₖ and -Cₖ by the selection control signal and outputs the selected signal. The signal output from multiplexer 54 is first frequency offset signal *sin*(ΔωT), which is Sₖ if Cₖ-Sₖ > 0 and Cₖ+Sₖ > 0, is -Cₖ if Cₖ-Sₖ < 0 and Cₖ+Sₖ > 0, is -Sₖ if Cₖ-Sₖ < 0 and Cₖ+Sₖ < 0, and is Cₖ if Cₖ-Sₖ > 0 and Cₖ+Sₖ < 0.

The description of the signal processor for generating frequency offset signal ΔωT in the preferred embodiments of Figures 7 and 8 has been omitted. However, those skilled in the art can construct such an apparatus which receives the frequency offset signal expressed as *sin*(ΔωT) to generate (ΔωT), using a ROM table.

The present invention can be used for the automatic frequency control of a modem using all types of MPSK modulation.

As described above, the apparatus according to present invention detects the frequency offset generated by the distance between the frequency of a carrier wave and the local oscillation frequency of a receiver or by the Doppler shift, using the transmission phase information and the phase difference information between the currently sampled signal and the immediately preceding sampled signal, thereby providing the effect of automatic frequency control in a MPSK communication method.

Also, according to the present invention, the frequency offset is detected using the signal sampled at a symbol rate, thereby resulting in the effect of cost reduction in the hardware for embodying the present invention.

## Claims

1. An automatic frequency control method, in which a MPSK-modulated signal is received, a frequency offset signal is generated using the phase information of the modulated signal, and the oscillation frequency of a receiver is controlled on the basis of the frequency offset signal, comprising the steps of:
sampling the received signal at a predetermined sampling frequency;
generating a phase detection signal having the phase difference information between the currently sampled signal and the immediately preceding sampled signal;
determining a reference phase which is the closest to the phase difference information of the phase detection signal among the reference phase values of the M-ary phase-shift keying of said modulated signal, as transmission phase information of said received signal; and
generating a frequency offset signal corresponding to the phase difference between said phase difference information and said determined transmission phase information.

2. An automatic frequency control method as claimed in claim 1, wherein said phase detection signal generating step comprises a normalization step where a first phase detection signal Uₖ is generated according to${\text{U}}_{\text{k}} \text{=} \frac{{\text{R}}_{\text{k}} {\text{R}}^{\text{*}} {\text{}}_{\text{k} \text{-1}}}{\left|{\text{R}}_{\text{k}}\right| \text{x} \left|{\text{R}}_{\text{k} \text{-1}}\right|} \text{=} \text{e} {\text{}}^{\text{j} {\text{(φ}}_{\text{k}} \text{+ΔωT)}} \text{≡} {\text{C}}_{\text{k}} \text{+} {\text{jS}}_{\text{k}}$ by using a currently sampled signal Rₖ and an immediately preceding sampled signal Rₖ₋₁ where φₖ represents the difference between phase information transmitted from the current symbol period and the phase information transmitted from the immediately preceding symbol period, and ΔωT is a frequency offset signal.

3. An automatic frequency control method as claimed in claim 1, wherein said phase detection signal generating step comprises a complex conjugation operation step where a second phase detection signal U'ₖ is generated according to${\text{U'}}_{\text{k}} {\text{= R}}_{\text{k}} {\text{R*}}_{\text{k-1}}$ by using a currently sampled signal Rₖ and an immediately preceding sampled signal Rₖ₋₁.

4. An automatic frequency control method as claimed in claim 1 or claim 2, wherein said frequency offset signal generating step comprises a first frequency offset signal generation step where a first frequency offset signal *sin*(ΔωT) is generated according to$\text{sin} {\text{(ΔωT) = Im[U}}_{\text{k}} {\text{e}}^{\text{-jψi}} \text{]}$ using said reference phase ψᵢ and said phase detection signal Uₖ.

5. An automatic frequency control method as claimed in claim 4, wherein said frequency offset signal generating step further comprises a second frequency offset signal generation step where a second frequency offset signal ΔωT is generated using the phase of said first frequency offset signal *sin*(ΔωT).

6. An automatic frequency control method as claimed in claim 5, wherein, in said transmission phase information determination step, when said phase difference information ∠Uₖ of phase detection signal Uₖ includes a second frequency offset signal ΔωT between -π/M and π/M determined according to the number M of the reference phase of the M-ary phase-shift keying, and when said phase difference information ∠Uₖ, second frequency offset signal ΔωT and transmission phase information θₖ satisfy ΔωT = ∠Uₖ - θₖ, a reference phase ψᵢ is determined as the reference phase which is the closest to said phase difference information.

7. An automatic frequency control apparatus, in which a MPSK-modulated signal is received, a frequency offset signal is generated using the phase information of the modulated signal, and the oscillation frequency of a receiver is controlled on the basis of the frequency offset signal, comprising:
sampling means (30) sampling the received signal at a predetermined sampling frequency and outputting the sampled signal (Rₖ);
phase difference detection means (32) receiving the currently sampled signal (Rₖ) from said sampling means (30) and for generating a phase detection signal (Uₖ) having phase difference information between the currently sampled signal (Rₖ) and the immediately preceding sampled signal (Rₖ₋₁) stored therein; and
means (34, 36) receiving said phase detection signal (Uₖ) to determine a reference phase which is the closest to said phase difference information of said phase detection signal (Uₖ) among the reference phase values of the M-ary phase-shift keying of said modulated signal, as transmission phase information of said received signal, and generating a frequency offset signal determined according to the phase difference between said phase difference information and said transmission phase information.

8. An automatic frequency control apparatus as claimed in claim 7, wherein said phase difference detection means (32) comprises normalization means for receiving the currently sampled signal (Rₖ) and the immediately preceding sampled signal (Rₖ₋₁) and generating said phase detection signal (Uₖ).

9. An automatic frequency control apparatus as claimed in claim 7, wherein said phase difference detection means (32) comprises a complex conjugation operator for receiving the currently sampled signal (Rₖ) and the immediately preceding sampled signal (Rₖ₋₁) and generating said phase detection signal (Uₖ).

10. An automatic frequency control apparatus as claimed in any one of claims 7 to 9, wherein said frequency offset signal generation means (34, 36) comprises:
determination means (34) for storing a plurality of critical values determined by said reference phase values, receiving said phase detection signal (Uₖ) and outputting the reference phase value determined by said phase difference information of said phase detection signal (Uₖ) and said plurality of critical values; and
first frequency offset signal generator (36) for receiving said transmission phase information and said phase detection signal (Uₖ) and generating first frequency offset signal which is an imaginary number component generated through the complex conjugation operation between the received transmission phase information and phase detection signal.

11. An automatic frequency control apparatus as claimed in claim 10, wherein said first frequency offset generator (36) receives said reference phase signal e^{-jψi} and said phase detection signal Uₖ from said determination means and generates a first frequency offset signal *sin*(ΔωT) determined according to$\text{sin} {\text{(ΔωT) = Im[U}}_{\text{k}} {\text{e}}^{\text{-jψi}} \text{]} {\text{= S}}_{\text{k}} \text{cos} {\text{ψ}}_{\text{i}} {\text{-C}}_{\text{k}} \text{sin} {\text{ψ}}_{\text{i}} \text{.}$

12. An automatic frequency control apparatus as claimed in claim 11, further comprising a second frequency offset signal generator (38) for receiving said first frequency offset signal (*sin*(ΔωT)) and generating a second frequency offset signal (ΔωT) through an arc sine operation.

13. An automatic frequency control apparatus as claimed in claim 12, wherein, in said determination means, when said phase difference information ∠Uₖ of said phase detection signal Uₖ includes a second frequency offset signal ΔωT between -π/M and π/M determined according to the number M of reference phase of phase-shift keying, and when said phase difference information ∠Uₖ, second frequency offset signal ΔωT and transmission phase information θₖ satisfy${\text{ΔωT = ∠U}}_{\text{k}} {\text{- θ}}_{\text{k}} \text{,}$ a reference phase ψᵢ is determined as the reference phase which is the closest to said phase difference information.

14. An automatic frequency control apparatus as claimed in any one of claims 7 to 13, wherein said sampling means (30) samples said received signal at the sampling frequency equal to the symbol rate.

15. An automatic frequency control apparatus as claimed in claim 7, wherein said frequency offset signal generator (40) comprises:
a first sign generator (41) for receiving the QPSK-modulated phase detection signal and generating a first sign signal which is the value of a sign function with respect to the difference obtained by subtracting a second component signal constituting said phase detection signal from first component signal constituting said phase detection signal;
a second sign generator (42) for generating a second sign signal which is the value of a sign function with respect to the sum of said first and second component signals;
a subtractor (43) for subtracting said second sign signal from said first sign signal;
a first adder (44) for summing said first and second sign signals;
a third sign generator (45) for outputting a third sign signal which is the sign function value of the signal output from said subtractor (43) ;
a fourth sign generator (46) for outputting a fourth sign signal which is the sign function value of the signal output from said adder (44) ;
a first multiplier (47) for multiplying said first component signal by the output signal of said third sign generator (45) ;
a second multiplier (48) for multiplying said second component signal by the output signal of said fourth sign generator (46); and
a second adder (49) for summing the output signals of said first and second multipliers (47, 48) and generating said first frequency offset signal.

16. An automatic frequency control apparatus as claimed in claim 7, wherein said frequency offset signal generator (50) comprises:
a control signal generator (51) for receiving the QPSK-modulated phase detection signal and generating a selection control signal determined according to a first sign function value with respect to the difference obtained by subtracting the second component signal constituting said phase detection signal from the first component signal constituting said phase detection signal and a second sign function value with respect to the sum of said first and second component signals, said control signal generator (51) generating said selection control signal so that the first component signal is selected as said first frequency offset signal if the first and second sign function values are greater than zero, the inverted signal of the first component signal is selected as said first frequency offset signal if the first sign function value is less than zero and the second sign function value is greater than zero, the inverted signal of the second component signal is selected as said first frequency offset signal if the first and second sign function values are less than zero, and the second component signal is selected as said first frequency offset signal if the first sign function value is greater than zero and the second sign function value is less than zero;
a first signal inverter (52) for inverting and outputting said first component signal;
a second signal inverter (53) for inverting and outputting said second component signal; and
selection means (54) comprising four signal inputs connected for receiving said first and second component signals and the output signals of said first and second signal inverters (52, 53), for selecting one of said four input signals according to said selection control signal and outputting said selected signal as said first frequency offset signal.

17. An automatic frequency control apparatus as claimed in claim 15 or claim 16, further comprising a second frequency offset signal generator for receiving said first frequency offset signal and generating a second frequency offset signal through an arc sign operation.

18. An automatic frequency control apparatus as claimed in any one of claims 15 to 17, wherein said first component signal is a real number component of said phase detection signal and said second component signal is an imaginary number component of said phase detection signal.

19. An automatic frequency control apparatus as claimed in any one of claims 15 to 18, wherein said sampling means samples said received signal at the sampling frequency equal to the symbol rate.

## Patentansprüche

1. Verfahren zur automatischen Frequenzregelung, bei dem ein MPSK-moduliertes Signal empfangen wird, ein Frequenzversatzsignal unter Verwendung der Phaseninformation des modulierten Signals erzeugt wird, und die Orts-Schwingungsfrequenz eines Empfängers auf der Grundlage des Frequenzversatzsignals geregelt wird, wobei es die folgenden Schritte umfaßt:
Abtasten des empfangenen Signals bei einer vorgegebenen Abtastfrequenz;
Erzeugen eines Phasenerfassungssignals mit der Information über die Phasendifferenz zwischen dem momentan abgetasteten Signal und dem unmittelbar vorangehenden abgetasteten Signal;
Bestimmen einer Bezugsphase, die am nächsten an der Phasendifferenzinformation des Phasenerfassungssignal unter den Bezugsphasenwerten der M-wertigen Phasenumtastung des modulierten Signal liegt, als Übertragungsphaseninformation des empfangenen Signals; und
Erzeugen eines Frequenzversatzsignals, das der Phasendifferenz zwischen der Phasendifferenzinformation und der bestimmten Übertragungsphaseninformation entspricht.

2. Verfahren zur automatischen Frequenzregelung nach Anspruch 1, wobei der Schritt der Erzeugung des Phasenerfassungssignals einen Normierungsschritt umfaßt, in dem ein erstes Phasenerfassungssignal Uₖ entsprechend${\text{U}}_{\text{k}} \text{=} \frac{{\text{R}}_{\text{k}} {\text{R}}^{\text{*}} {\text{}}_{\text{k} \text{-1}}}{\left|{\text{R}}_{\text{k}}\right| \text{x} \left|{\text{R}}_{\text{k} \text{-1}}\right|} \text{=} \text{e} {\text{}}^{\text{j} {\text{(φ}}_{\text{k}} \text{+Δω} \text{T} \text{)}} {\text{= C}}_{\text{k}} {\text{+ jS}}_{\text{k}}$ erzeugt wird, indem ein momentan abgetastetes Signal Rₖ und ein unmittelbar vorangehendes abgetastetes Signal Rₖ₋₁ genutzt werden, wobei φₖ die Differenz zwischen der Phaseninformation, die von der momentanen Zeichenperiode übertragen wird, und der Phaseninformation, die von der unmittelbar vorangehenden Zeichenperiode übertragen wurde, darstellt, und ΔωT ein Frequenzversatzsignal ist.

3. Verfahren zur automatischen Frequenzsteuerung nach Anspruch 1, wobei der Schritt der Erzeugung des Phasenerfassungssignals einen Schritt umfaßt, in dem eine komplexe Konjugation ausgeführt wird,und in dem das zweite Phasenerfassungssignal U'ₖ entsprechend${\text{U'}}_{\text{k}} {\text{= R}}_{\text{k}} {\text{R*}}_{\text{k-1}}$ erzeugt wird, wobei ein momentan abgetastetes Signal Rₖ und ein unmittelbar vorangehendes abgetastetes Signal Rₖ₋₁ genutzt werden.

4. Verfahren zur automatischen Frequenzsteuerung nach Anspruch 1 oder Anspruch 2, wobei der Schritt des Erzeugens des Frequenzversatzsignals einen Schritt zum Erzeugen eines ersten Frequenzversatzsignals umfaßt, in dem ein erstes Frequenzversatzsignal *sin*(ΔωT) entsprechend$\text{sin} {\text{(ΔωT) = Im[U}}_{\text{k}} {\text{e}}^{\text{-jψi}} \text{]}$ erzeugt wird, wobei die Bezugsphase ψi und das Phasenerfassungssignal Uₖ genutzt werden.

5. Verfahren zur automatischen Frequenzregelung nach Anspruch 4, wobei der Schritt des Erzeugens des Frequenzversatzsignals einen Schritt zum Erzeugen eines zweiten Frequenzversatzsignals umfaßt, in dem ein zweites Frequenzversatzsignal ΔωT unter Verwendung der Phase des ersten Frequenzversatzsignals sin((ΔωT) erzeugt wird.

6. Verfahren zur automatischen Frequenzregelung nach Anspruch 5, wobei in dem Schritt zum Bestimmen der Übertragungsphaseninformation, wenn die Phasendifferenzinformation ∠Uₖ des Phasenerfassungssignals Uₖ ein zweites Frequenzversatzsignal ΔωT zwischen -π/M und π/M enthält, das entsprechend der Anzahl M der Bezugsphase der M-wertigen Phasenumtastung bestimmt wird, und wenn die Phasendifferenzinformation ∠Uₖ, das zweite Frequenzversatzsignal ΔωT und die Übertragungsphaseninformation θₖ ΔωT = Uₖ-θₖ erfüllen, eine Bezugsphase ψᵢ als die Referenzphase bestimmt wird, die am nächsten an der Phasendifferenzinformation liegt.

7. Automatische Frequenzregelungsvorrichtung, in der ein MPSK-moduliertes Signal empfangen wird, ein Frequenzversatzsignal unter Verwendung der Phaseninformation des modulierten Signals erzeugt wird, und die Orts-Schwingungsfrequenz eines Empfängers auf der Grundlage des Frequenzversatzsignal geregelt wird, die umfaßt:
eine Abtasteinrichtung (30), die das empfangene Signal bei einer vorgegebenen Abtastfrequenz abtastet und das abgetastete Signal (Rₖ) ausgibt;
eine Phasendifferenz-Erfassungsschaltung (32), die das momentane abgetastete Signal (Rₖ) von der Abtasteinrichtung (30) empfängt und ein Phasenerfassungssignal (Uk) erzeugt, das Information über die Phasendifferenz zwischen dem momentan abgetasteten Signal (Rk) und dem unmittelbar vorangehenden abgetasteten Signal (Rₖ₋₁) aufweist, das darin gespeichert ist;
eine Einrichtung (34, 36) zum Empfangen des Phasenerfassungssignals (Uk), um eine Bezugsphase zu bestimmen, die am nächsten an der Phasendifferenzinformation des Phasenerfassungssignal (Uk) unter den Bezugsphasenwerten der M-wertigen Phasenumtastung des modulierten Signals (Uk) liegt, als Übertragungsphaseninformation des empfangenen Signals, und zum Erzeugen eines Frequenzversatzsignals, das entsprechend der Phasendifferenz zwischen der Phasendifferenzinformation und der Übertragungsphaseninformation bestimmt wird.

8. Automatische Frequenzregelungsvorrichtung nach Anspruch 7, wobei die Phasendifferenz-Erfassungeinrichtung (32) eine Normierungseinrichtung umfaßt, die das momentan abgetastete Signal (Rₖ) und das unmittelbar vorangehende abgetastete Signal (Rₖ₋₁) empfängt und das Phasenerfassungssignal (Uₖ) erzeugt.

9. Automatische Frequenzregelungsvorrichtung nach Anspruch 7, wobei die Phasendifferenz-Erfassungeinrichtung (32) eine Einrichtung umfaßt, die komplexe Konjugation ausführt und das momentan abgetastete Signal (Rₖ) und das unmittelbar vorangehende abgetastete Signal (Rₖ₋₁) empfängt und das Phasenerfassungssignal (Uₖ) erzeugt.

10. Automatische Frequenzregelungsvorrichtung nach einem der Ansprüche 7 bis 9, wobei die Frequenzversatzsignal-Erzeugungseinrichtung (34, 36) umfaßt:
eine Bestimmungseinrichtung (34), die eine Vielzahl kritischer Werte speichert, die von den Bezugsphasenwerten bestimmt werden, das Phasenerfassungssignal (Uₖ) empfängt und den Bezugsphasenwert ausgibt, der durch die Phasendifferenzinformation des Phasenerfassungssignals (Uₖ) und die Vielzahl kritischer Werte bestimmt wird; und
eine Einrichtung (36) zum Erzeugen eines ersten Frequenzversatzsignals, die die Übertragungsphaseninformation und das Phasenerfassungssignal (Uk) empfängt und das erste Frequenzversatzsignal erzeugt, das eine imaginäre Zahlenkomponente ist, die über den Vorgang komplexer Konjugation zwischen der empfangenen Übertragungsphaseninformation und dem Phasenerfassungssignal erzeugt wird.

11. Automatische Frequenzregelungsvorrichtung nach Anspruch 10, wobei die erste Frequenzversatzsignal-Erzeugungseinrichtung (36) das Bezugsphasensignal e^{-jψi} und das Phasenerfassungssignal Uₖ von der Bestimmungseinrichtung empfängt und ein erstes Frequenzversatzsignal sin(ΔωT) erzeugt, das entsprechend$\text{sin} {\text{(ΔωT) = ImU}}_{\text{k}} {\text{e}}^{\text{-jψi}} \text{]} {\text{= S}}_{\text{k}} \text{cos} {\text{ψ}}_{\text{i}} {\text{- C}}_{\text{k}} \text{sin} {\text{ψ}}_{\text{i.}}$ bestimmt wird.

12. Automatische Frequenzregelungsvorrichtung nach Anspruch 11, die des weiteren eine zweite Frequenzversatz-Signalerzeugungseinrichtung (38) umfaßt, die das erste Frequenzversatzsignal (*sin*(ΔωT)) 11empfängt und ein zweites Frequenzversatzsignal (ΔωT) über eine Arcussinus-Operation erzeugt.

13. Automatische Frequenzregelungsvorrichtung nach Anspruch 12, wobei in der Bestimmungseinrichtung, wenn die Phasendifferenzinformation ∠Uₖ des Phasenerfasssungsignals Uₖ ein zweites Frequenzversatzsignal ΔωT zwischen -π/M und π/M enthält, das entsprechend der Zahl M der Bezugsphase der Phasenumtastung bestimmt wird, und wenn die Phasendifferenzinformation ∠Uₖ, das zweite Frequenzversatzsiginal ΔωT und die Übertragungsphaseninformation θₖ ΔωT= ∠Uₖ-θₖ erfüllen, eine Bezugsphase ψᵢ als die Bezugsphase bestimmt wird, die am nächsten an der Phasendifferenzinformation liegt.

14. Automatische Frequenzregelungsvorrichtung nach einem der Ansprüche 7 bis 13, wobei die Abtasteinrichtung (30) das empfangene Signal bei der Abtastfrequenz abtastet, die gleich der Zeichenrate ist.

15. Automatische Frequenzregelungsvorrichtung nach Anspruch 7, wobei die Frequenzversatzsignal-Erzeugungseinrichtung (40) umfaßt:
eine erste Vorzeichen-Erzeugungseinrichtung (41), die das QPSK-modulierte Phasenerfassungssignal empfängt und ein erstes Vorzeichensignal erzeugt, das der Wert einer Vorzeichenfunktion in Bezug auf die Differenz ist, die bestimmt wird, indem ein Signal einer zweiten Komponente, das das Phasenerfassungssignal bildet, von einem Signal einer ersten Komponente subtrahiert wird, das das Phasenerfassungssignal bildet;
eine zweite Vorzeichen-Erzeugungseinrichtung (42), die ein zweites Vorzeichensignal erzeugt, das der Wert einer Vorzeichenfunktion in Bezug auf die Summe der Signale der ersten und der zweiten Komponente ist;
einen Subtrahierer (43), der das Signal des zweiten Vorzeichens von dem Signal des ersten Vorzeichens subtrahiert;
einen ersten Addierer (44), der das Signal des ersten und des zweiten Vorzeichens addiert;
eine dritte Vorzeichen-Erzeugungseinrichtung (45), die ein Signal eines dritten Vorzeichens ausgibt, das der Signalfunktionswert des von dem Subtrahierer (43) ausgegebenen Signal ist;
eine vierte Vorzeichen-Erzeugungseinrichtung (46), die ein viertes Vorzeichensignal ausgibt, das der Vorzeichenfunktionswert des von dem Addierer (44) ausgegebenen Signals ist;
einen ersten Multiplizierer (47), der das Signal der ersten Komponente mit dem Ausgangssignal der dritten Vorzeichen-Erzeugungseinrichtung (45) multipliziert;
einen zweiten Multiplizierer (48), der das Signal der zweiten Komponente mit dem Ausgangssignal der vierten Vorzeichen-Erzeugungseinrichtung (46) multipliziert; und
einen zweiten Addierer (49), der die Ausgangssignale des ersten und des zweiten Multiplizierers (47, 48) addiert und das erste Frequenzversatzsignal erzeugt.

16. Automatische Frequenzregelungsvorrichtung nach Anspruch 7, wobei die Frequenzversatzsignal-Erzeugungseinrichtung (50) umfaßt:
eine Steuersignal-Erzeugungseinrichtung (51), die das QPSK-modulierte Phasenerfassungssignal empfängt und ein Auswahl-Steuersignal erzeugt, das entsprechend einem ersten Vorzeichenfunktionswert bezüglich der Differenz bestimmt wird, die ermittelt wird, indem das Signal der zweiten Komponente, das das Phasenerfassungssignal bildet, von dem Signal der ersten Komponente, das das Phasenerfassungssignal bildet, subtrahiert wird, sowie gemäß einem zweiten Vorzeichenfunktionswert bezüglich der Summe aus dem Signal der ersten und dem Signal der zweiten Komponente, wobei die Steuersignal-Erzeugungseinrichtung (51) das Auswahl-Steuersignal so erzeugt, daß das Signal der ersten Komponente als das erste Frequenzversatzsignal ausgewählt wird, wenn der Wert der ersten und der zweiten Vorzeichenfunktion größer sind als null, das umgekehrte Signal des Signals der ersten Komponente als das erste Frequenzversatzsignal ausgewählt wird, wenn der Wert der ersten Vorzeichenfunktion kleiner ist als Null und der Wert der zweiten Vorzeichenfunktion größer ist als Null, das umgekehrte Signal des Signals der zweiten Komponente als das erste Frequenzversatzsignal ausgewählt wird, wenn der Wert der ersten Vorzeichenfunktion und der zweiten Vorzeichenfunktion kleiner sind als Null, und das Signal der zweiten Komponente als das erste Frequenzversatzsignal ausgewählt wird, wenn der Wert der ersten Vorzeichenfunktion größer ist als Null und der Wert der zweiten Vorzeichenfunktion kleiner ist als Null;
eine erste Signal-Umkehreinrichtung (52), die das Signal der ersten Komponente umkehrt und ausgibt;
eine zweite Signal-Umkehreinrichtung (53), die das Signal der zweiten Komponente umkehrt und ausgibt; und
eine Auswahleinrichtung (54), die vier Signaleingänge umfaßt, die so geschaltet sind, daß sie das Signal der ersten und das Signal der zweiten Komponente und die Ausgangssignale der ersten und der zweiten Signal-Umkehreinrichtung (52, 53) empfangen, um eines der vier Eingangssignale entsprechend dem Auswahl-steuersignal auszuwählen und das ausgewählte Signal als das erste Frequenzversatzsignal auszugeben.

17. Automatische Frequenzregelungsvorrichtung nach Anspruch 15 oder Anspruch 16, die des weiteren eine zweite Frequenzversatz-Signalerzeugungseinrichtung umfaßt, die das erste Frequenzversatzsignal empfängt und ein zweites Frequenzversatzsignal über eine Arcussinusoperation erzeugt.

18. Automatische Frequenzregelungsvorrichtung nach einem der Ansprüche 15 bis 17, wobei das Signal der ersten Komponente eine reelle Zahlenkomponente des Phasenerfassungssignals ist und das Signal der zweiten Komponente eine imaginäre Zahlenkomponente des Phasenerfassungssignals ist.

19. Automatische Frequenzregelungsvorrichtung nach einem der Ansprüche 15 bis 18, wobei die Abtasteinrichtung das empfangene Signal bei der Abtastfrequenz abtastet, die der Zeichenrate gleich ist.

## Revendications

1. Procédé de commande de fréquence automatique dans lequel est reçu un signal à modulation par déplacement de phase à M états, un signal de décalage de fréquence est généré en utilisant l'information de phase du signal modulé et la fréquence d'oscillation d'un récepteur est contrôlée en fonction du signal de décalage de fréquence, comprenant les étapes consistant à :
échantillonner le signal reçu selon une fréquence d'échantillonnage prédéterminée ;
générer un signal de détection de phase dont l'information de différence de phase se trouve entre le signal en cours d'échantillonnage et le signal échantillonné immédiatement précédent ;
déterminer une phase de référence qui est la plus proche de l'information de différence de phase du signal de détection de phase parmi les valeurs de phase de référence de la modulation par déplacement de phase à M états dudit signal modulé, en tant qu'information de phase d'émission dudit signal reçu ; et
générer un signal de décalage de fréquence correspondant à la différence de phase entre ladite information de différence et ladite information de phase d'émission déterminée.

2. Procédé de commande de fréquence automatique selon la revendication 1, dans lequel ladite étape de génération de signal de détection de phase comprend une étape de normalisation dans laquelle un premier signal de détection de phase Uₖ est généré conformément à l'expression${\text{U}}_{\text{k}} \text{=} \frac{{\text{R}}_{\text{k}} {\text{R*}}_{\text{k-1}}}{\left|{\text{R}}_{\text{k}}\right| \text{x} \left|{\text{R}}_{\text{k-1}}\right|} \text{=} \text{e} {\text{}}^{\text{j(} {\text{φ}}_{\text{k}} \text{+Δω} \text{T)}} \text{=} {\text{C}}_{\text{k}} \text{+} {\text{jS}}_{\text{k}}$ en utilisant un signal en cours d'échantillonnage Rₖ et un signal échantillonné immédiatement précédent Rₖ₋₁ où φₖ représente la différence entre l'information de phase émise pour la période de symbole en cours et l'information de phase émise pour la période de symbole immédiatement précédente et ΔωT est un signal de décalage de fréquence.

3. Procédé de commande de fréquence automatique selon la revendication 1, dans lequel ladite étape de génération de signal de détection de phase comprend une opération de conjugaison complexe dans laquelle un second signal de détection de phase U'ₖ est généré conformément à l'expression${\text{U'}}_{\text{k}} {\text{= R}}_{\text{k}} {\text{R*}}_{\text{k-1}}$ en utilisant un signal en cours d'échantillonnage Rₖ et un signal échantillonné immédiatement précédent Rₖ₋₁.

4. Procédé de commande de fréquence automatique selon la revendication 1 ou la revendication 2, dans lequel ladite étape de génération de signal de décalage de fréquence comprend une première étape de génération de signal de décalage de fréquence dans laquelle un premier signal de décalage de fréquence sin(ΔωT) est généré selon l'expression${\text{sin(ΔωT) = Im[U}}_{\text{k}} {\text{e}}^{\text{-jΨi}} \text{]}$ en utilisant ladite phase de référence Ψᵢ et ledit signal de détection de phase Uₖ.

5. Procédé de commande de fréquence automatique selon la revendication 4, dans lequel ladite étape de génération de signal de décalage de fréquence comprend en outre une seconde étape de génération de signal de décalage de fréquence dans laquelle un second signal de décalage de fréquence ΔωT est généré en utilisant la phase dudit premier signal de décalage de fréquence sin(ΔωT).

6. Procédé de commande de fréquence automatique selon la revendication 5, dans lequel, pendant ladite étape de détermination de l'information de phase d'émission, lorsque ladite information de différence de phase ∠Uₖ du signal de détection de phase Uₖ comprend un second signal de décalage de fréquence ΔωT entre -π/M et π/M déterminé en fonction du nombre M de la phase de référence de la modulation par déplacement de phase à M états, et lorsque ladite information de différence de phase ∠Uₖ, le second signal de décalage de fréquence ΔωT et l'information de phase d'émission θₖ satisfont l'expression ΔωT = ∠Uₖ - θₖ, une phase de référence Ψᵢ est déterminée pour former la phase de référence qui est la plus proche de ladite information de différence de phase.

7. Dispositif de commande de fréquence automatique, dans lequel un signal à modulation par déplacement de phase à M états est reçu, un signal de décalage de fréquence est généré en utilisant l'information de phase du signal modulé et la fréquence d'oscillation d'un récepteur est contrôlée en fonction du signal de décalage de fréquence, comprenant :
un moyen d'échantillonnage (30) échantillonnant le signal reçu à une fréquence d'échantillonnage prédéterminée et produisant le signal échantillonné (Rₖ) ;
un moyen de détection de différence de phase (32) recevant le signal en cours d'échantillonnage (Rₖ) provenant dudit moyen d'échantillonnage (30) et générant un signal de détection de phase (Uₖ) ayant une information de différence de phase entre le signal en cours d'échantillonnage (Rₖ) et le signal échantillonné immédiatement précédent (Rₖ₋₁) qui y est stocké ; et
un moyen (34, 36) recevant ledit signal de détection de phase (Uₖ) afin de déterminer une phase de référence qui est la plus proche de ladite information de différence de phase dudit signal de détection de phase (Uₖ) parmi les valeurs de phase de référence de la modulation par déplacement de phase à M états dudit signal modulé, en tant qu'information de phase d'émission dudit signal reçu et générant un signal de décalage de fréquence déterminé en fonction de la différence de phase entre ladite information de différence de phase et ladite information de phase d'émission.

8. Dispositif de commande de fréquence automatique selon la revendication 7, dans lequel ledit moyen de détection de différence de phase (32) comprend un moyen de normalisation destiné à recevoir le signal en cours d'échantillonnage (Rₖ) et le signal échantillonné immédiatement précédent (Rₖ₋₁) et à générer ledit signal de détection de phase (Uₖ).

9. Dispositif de commande de fréquence automatique selon la revendication 7, dans lequel ledit moyen de détection de différence de phase (32) comprend un opérateur de conjugaison complexe destiné à recevoir le signal en cours d'échantillonnage (Rₖ) et le signal échantillonné immédiatement précédent (Rₖ₋₁) et à générer ledit signal de détection de phase (Uₖ).

10. Dispositif de commande de fréquence automatique selon l'une quelconque des revendications 7 à 9, dans lequel ledit moyen de génération de signal de décalage de fréquence (34, 36) comprend :
un moyen de détermination (34) destiné à stocker une multiplicité de valeurs critiques déterminées par lesdites valeurs de phase de référence, à recevoir ledit signal de détection de phase (Uₖ) et à produire la valeur de phase de référence déterminée par ladite information de différence de phase dudit signal de détection de phase (Uₖ) et de ladite multiplicité de valeurs critiques ; et
un premier générateur de signal de décalage de fréquence (36) destiné à recevoir ladite information de phase d'émission et ledit signal de détection de phase (Uₖ) et à générer un premier signal de décalage de fréquence qui est une composante de nombre imaginaire générée au moyen de l'opération de conjugaison complexe entre l'information de phase d'émission reçue et le signal de détection de phase.

11. Dispositif de commande de fréquence automatique selon la revendication 10, dans lequel ledit premier générateur de décalage de fréquence (36) reçoit ledit signal de phase de référence e^{-jΨi} et ledit signal de détection de phase Uₖ dudit moyen de détermination et génère un premier signal de décalage de fréquence sin(ΔωT) déterminé conformément à l'expression${\text{sin(ΔωT) = Im[Uk e}}^{\text{-jΨi}} \text{]} {\text{= S}}_{\text{k}} {\text{cosΨ}}_{\text{i}} {\text{-C}}_{\text{k}} {\text{sinΨ}}_{\text{i}} \text{.}$

12. Dispositif de commande de fréquence automatique selon la revendication 11, comprenant en outre un second générateur de signal de décalage de fréquence (38) destiné à recevoir ledit premier signal de décalage de fréquence (sin(ΔωT)) et à générer un second signal de décalage de fréquence (ΔωT) au moyen d'une opération arc sinus.

13. Dispositif de commande de fréquence automatique selon la revendication 12, dans lequel, dans ledit moyen de détermination, lorsque ladite information de différence de phase ∠Uₖ dudit signal de détection de phase Uₖ comprend un second signal de décalage de fréquence ΔωT entre -π/M et π/M déterminé en fonction du nombre M de la phase de référence de la modulation par déplacement de phase, et lorsque ladite information de différence de phase ∠Uₖ, le second signal de décalage de fréquence ΔωT et l'information de phase d'émission θₖ satisfont l'expression ΔωT = ∠Uₖ - θₖ, une phase de référence Ψᵢ est déterminée pour former la phase de référence qui est la plus proche de ladite information de différence de phase.

14. Dispositif de commande de fréquence automatique selon l'une quelconque des revendications 7 à 13, dans lequel ledit moyen d'échantillonnage (30) échantillonne ledit signal reçu à la fréquence d'échantillonnage égale au débit de symboles.

15. Dispositif de commande de fréquence automatique selon la revendication 7 dans lequel ledit générateur de signal de décalage de fréquence (40) comprend :
un premier générateur de signe (41) destiné à recevoir le signal de détection de phase à modulation par déplacement de phase quaternaire et à générer un premier signal de signe qui est la valeur d'une fonction de signe relativement à la différence obtenue en soustrayant une seconde composante de signal constituant ledit signal de détection de phase de la première composante de signal constituant ledit signal de détection de phase ;
un second générateur de signe (42) destiné à générer un second signal de signe qui est la valeur d'une fonction de signe relativement à la somme desdits premier et second signaux de composantes ;
un soustracteur (43) destiné à soustraire ledit second signal de signe dudit premier signal de signe ;
un premier additionneur (44) destiné à sommer lesdits premier et second signaux de signe ;
un troisième générateur de signe (45) destiné à produire un troisième signal de signe qui est la valeur de la fonction de signe de la sortie de signal provenant dudit soustracteur (43) ;
un quatrième générateur de signe (46) destiné à produire un quatrième signal de signe qui est la valeur de la fonction de signe de la sortie de signal provenant dudit additionneur (44) ;
un premier multiplicateur (47) destiné à multiplier ledit premier signal de composante par le signal de sortie dudit troisième générateur de signe (45) ;
un second multiplicateur (48) destiné à multiplier ledit second signal de composante par le signal de sortie dudit quatrième générateur de signe (46) ; et
un second additionneur (49) destiné à sommer les signaux de sortie desdits premier et second multiplicateurs (47, 48) et à générer ledit premier signal de décalage de fréquence.

16. Dispositif de commande de fréquence automatique selon la revendication 7, dans lequel ledit générateur de signal de décalage de fréquence (50) comprend :
un générateur de signal de commande (51) destiné à recevoir le signal de détection de phase à modulation par déplacement de phase quaternaire et à générer un signal de commande de sélection déterminé en fonction d'une première fonction de valeur de signe relativement à la différence obtenue en soustrayant le second signal de composante constituant ledit signal de détection de phase du premier signal de composante constituant ledit signal de détection de phase et d'une seconde fonction de valeur de signe relativement à la somme desdits premier et second signaux de composantes, ledit générateur de signal de commande (51) générant ledit signal de commande de sélection de sorte que le premier signal de composante soit sélectionné pour former ledit premier signal de décalage de fréquence si les première et seconde valeurs de fonction de signe sont supérieures à zéro, que le signal inversé du premier signal de composante soit sélectionné pour former ledit premier signal de décalage de fréquence si la première valeur de fonction de signe est inférieure à zéro et la seconde valeur de fonction de signe est supérieure à zéro, que le signal inversé du second signal de composante soit sélectionné pour former le premier signal de décalage de fréquence si la première et la seconde valeurs de fonction de signe sont inférieures à zéro et que la seconde valeur de signal de composante soit sélectionnée pour former le premier signal de décalage de fréquence si la première valeur de fonction de signe est supérieure à zéro et la seconde valeur de fonction de signe est inférieure à zéro ;
un premier inverseur de signal (52) destiné à inverser et à produire ledit premier signal de composante ;
un second inverseur de signal (53) destiné à inverser et à produire ledit second signal de composante ; et
un moyen de sélection (54) comprenant quatre entrées de signal reliées afin de recevoir lesdits premier et second signaux de composante et les signaux de sortie desdits premier et second inverseurs de signaux (52, 53), afin de sélectionner un desdits quatre signaux d'entrée selon ledit signal de commande de sélection et de produire ledit signal sélectionné formant le premier signal de décalage de fréquence.

17. Dispositif de commande de fréquence automatique selon la revendication 15 ou 16, comprenant en outre un second générateur de signal de décalage de fréquence destiné à recevoir ledit premier signal de décalage de fréquence et à générer un second signal de décalage de fréquence au moyen d'une opération arc sinus.

18. Dispositif de commande de fréquence automatique selon l'une quelconque des revendications 15 à 17, dans lequel ledit premier signal de composante est une composante de nombre réel dudit signal de détection de phase et ledit second signal de composante est une composante de nombre imaginaire dudit signal de détection de phase.

19. Dispositif de commande de fréquence automatique selon l'une quelconque des revendications 15 à 18, dans lequel ledit moyen d'échantillonnage échantillonne ledit signal reçu à la fréquence d'échantillonnage égale au débit de symboles.
